# EUROPÄISCHE PATENTSCHRIFT

(11) **EP 2 844 414 B1**
(45) Veröffentlichungstag und Bekanntmachung des Hinweises auf die Patenterteilung: **16.08.2017**
(21) Anmeldenummer: 13724147.7
(22) Anmeldetag: 08.04.2013
(51) Int. Cl.: B23K 1/00, B23K 1/20, C23C 18/08, C23C 18/12, H01L 21/48, H05K 3/10

(54) **VERFAHREN ZUR HERSTELLUNG EINES METALLISIERTEN AUS ALUMINIUM BESTEHENDEN SUBSTRATS**
METHOD OF PRODUCING A METALLISED SUBSTRATE CONSISTING OF ALUMINIUM
PROCÉDÉ DE FABRICATION D'UN SUBSTRAT MÉTALLISÉ COMPOSÉ D'ALUMINIUM

(30) Priorität: 04.05.2012 AT 5272012
(43) Veröffentlichungstag der Anmeldung: 11.03.2015
(73) Patentinhaber: A.B. Mikroelektronik Gesellschaft mit beschränkter Haftung, 5020 Salzburg (AT)
(72) Erfinder: BURNS, Robert Christopher, A-5020 Salzburg (AT); TUSLER, Wolfgang, A-5020 Salzburg (AT); HAEGELE, Bernd, 84549 Engelsberg (DE)
(74) Vertreter: Torggler & Hofinger Patentanwälte
(86) Internationale Anmeldenummer: PCT/AT2013/000059
(87) Internationale Veröffentlichungsnummer: WO 2013/163663

(56) Entgegenhaltungen:
- EP-A2- 0 543 121
- WO-A2-2007/128015
- JP-A- S5 441 233
- JP-A- S5 441 234
- US-A- 5 256 469
- US-A- 5 882 722
- US-A- 6 074 893
- US-B1- 6 736 988
- DATABASE WPI Week 199249 Thomson Scientific, London, GB; AN 1992-404015 XP002711751, -& JP H04 302194 A (MURATA MFG CO LTD) 26. Oktober 1992 (1992-10-26)

## Beschreibung

Die Erfindung betrifft ein Verfahren zur Herstellung eines metallisierten Substrats gemäß dem Oberbegriff des Anspruchs 1 (siehe, z.B., JP S54 41233 A). Metallisierte Substrate sind z.B. aus JP S54 41233 A, US 6,736,988 B1, EP 0 534 121 A2 und WO 2007/128015 A2 bekannt.

Der Werkstoff Aluminium erfährt insbesondere im Bereich der Leistungselektronik eine zunehmend höhere Bedeutung. Durch sein verhältnismäßig geringes Gewicht und die geringen Kosten wird Aluminium häufig als Kühlkörper für elektronische Bauteile wie beispielsweise Leistungselektronikmodule (z.B. LEDs, IGBTs oder MOSFETs) oder auch direkt als stromführender Leiter, insbesondere als Strom- oder Sammelschiene, eingesetzt. Aluminium weist für diese Einsatzzwecke sowohl eine sehr hohe Wärmeleitfähigkeit von etwa 235 W/(m*K) als auch eine sehr hohe elektrische Leitfähigkeit von etwa 37*10⁶ A/(V*m) auf. Eine chemische Eigenschaft von Aluminium ist eine sich sehr schnell an der Luft bildende dünne Oxidschicht, die sich durch Kontakt mit Sauerstoff in der Atmosphäre in Folge eines Oxidationsprozesses an der Oberfläche eines Aluminiumkörpers bildet. Diese Oxidschicht bietet zwar einerseits einen Korrosionsschutz, erschwert aber andererseits die Verbindung von Aluminium mit anderen Werkstoffen durch Löten, Schweißen oder andere bekannte Verbindungstechniken.

Die Erfindung hat es sich daher zur Aufgabe gemacht, ein verbessertes Verfahren zur Herstellung eines metallisierten Substrats, das überwiegend aus Aluminium und/oder einer Aluminiumlegierung besteht, anzugeben. Insbesondere soll erreicht werden, die Oberfläche des Substrats lötbar zu machen, um eine elektrische Kontaktierung mit dem Substrat herstellen zu können.

Diese Aufgabe wird erfindungsgemäß durch ein Verfahren zur Herstellung eines metallisierten Substrats gemäß Anspruch 1 gelöst. Vorteilhafte Ausgestaltungen der Erfindung sind in den abhängigen Patentansprüchen angegeben.

Gemäß der Erfindung ist also vorgesehen, dass auf einer Oberfläche des Substrats zumindest bereichsweise eine Leiterpaste umfassend zumindest ein Metallpulver, ein anorganisches Pulver sowie organische Binde- und Lösemittel aufgebracht wird, in einer ersten Brennphase die Leiterpaste einer im Wesentlichen kontinuierlich steigenden Brenntemperatur ausgesetzt wird, wobei in der ersten Brennphase (B₁) die Brenntemperatur (T) zumindest zeitweise um etwa 40 °C/min bis etwa 60 °C/min erhöht wird, wobei die Brenntemperatur auf eine vorgebbare maximale Brenntemperatur kleiner etwa 660 °C erhöht wird, in einer zweiten Brennphase die Leiterpaste für einen vorgebbaren Zeitraum im Wesentlichen der vorgebbaren maximalen Brenntemperatur ausgesetzt wird, in einer Abkühlphase die Leiterpaste abgekühlt wird und in einer Nachbehandlungsphase eine Oberfläche der Leiterpaste mechanisch nachbehandelt, vorzugsweise gebürstet, wird.

Durch die angegebenen Verfahrensschritte kann die Oberfläche eines Substrats, insbesondere eines Aluminiumsubstrats, zuverlässig metallisiert werden. Die Bereiche, an denen durch das angegebene Verfahren die Leiterpaste aufgebracht und entsprechend den Verfahrensschritten gesintert wird, treten zur elektrischen Kontaktierung des Substrats anstelle der in diesem Bereich vorherrschenden, oxidierten Oberfläche des Substrats. Diese elektrisch leitfähige Schicht, die zumindest bereichsweise durch das Auftragen und Sintern der Leiterpaste erzielt wird, kann in weiterer Folge beispielsweise zum Anlöten eines elektronischen Bauteils oder auch zum Anlöten eines Kühlkörpers verwendet werden, wobei der Kühlkörper selbst wiederum aus Aluminium bestehen kann.

Das Substrat kann dabei zumindest teilweise, vorzugsweise vollständig, aus einem Aluminium-Werkstoff mit einem möglichst hohen Aluminium-Anteil bestehen. Vorzugsweise kommt ein Aluminium-Werkstoff mit der Güte EN AW-1050A oder EN AW-1060A nach Europäischer Norm EN 573 zum Einsatz, der mindestens 99,5 Gew.-% bzw. 99,6 Gew.-% Aluminium enthält. Trotz etwas geringerer Liquidustemperaturen und geringerer Wärmeleitfähigkeit im Vergleich zu den vorgenannten im Wesentlichen puren Aluminium-Werkstoffen können auch Aluminiumlegierungen eingesetzt werden, beispielsweise Aluminiumlegierungen umfassend Mangan oder Magnesium wie z.B. EN AW-3003 (AlMn1Cu), EN AW-3103 (AlMn1), EN AW-5005 (AlMg1) oder EN AW-5754 (AlMg3).

Durch das vorgeschlagene Verfahren erhält man die Möglichkeit, selektiv einzelne Bereiche der Oberfläche eines Aluminium-basierten Substrats zu metallisieren, wobei die metallisierten Bereiche in Form einer gesinterten Leiterpaste direkt stoffschlüssig mit dem Substrat verbunden sind und sich dadurch eine hohe elektrische Leitfähigkeit und eine hohe thermische Leitfähigkeit von Leiterpaste zu Substrat und umgekehrt erzielen lässt. Die metallisierten Bereiche stellen darüber hinaus lötbare Bereiche dar, durch die das Substrat in bekannter Art und Weise mit weiteren Komponenten verbunden werden kann. So können beispielsweise unter Verwendung von herkömmlichen Lötmitteln wie eutektischen Sn-Pb-, Sn-Ag-Cu- oder Sn-Au-Loten einzelne elektronische Bauteile auf die metallisierten Bereiche aufgelötet werden.

Für eine verbesserte Wärmeabfuhr können durch die metallisierten Bereiche auch potentialfreie Anschlüsse von Komponenten wie Hochleistungs-LED-Modulen oder Leistungselektronik-Modulen auf ein Aluminiumsubstrat angelötet werden, ohne eine dazwischenliegende isolierende dielektrische Schicht und ohne eine teure Silberbasierte Wärmeleitpaste verwenden zu müssen, wodurch sich insgesamt ein geringerer Wärmewiderstand erzielen lässt. Durch den verringerten Wärmewiderstand und die erhöhte Wärmeleitfähigkeit können die Baugrößen der mit dem Substrat verbundenen Komponenten verringert werden oder diese mit höheren Leistungsabgaben betrieben werden. Zum Anlöten der Komponenten an die metallisierten Bereiche können herkömmliche Lötmittel (siehe oben) verwendet werden. Es kann somit auf spezielle Aluminium-Lötmittel verzichtet werden, die oftmals Halogene und andere gesundheitsschädliche Stoffe enthalten.

Ein weiterer Einsatzbereich des vorgeschlagenen Verfahrens ist das Metallisieren von Aluminium-Stromschienen zur Verbesserung der Zuverlässigkeit der Verbindungen mit damit verbundenen Stromkabeln. Durch ein Metallisieren der Oberfläche einer Aluminium-Stromschiene mit einer Kupfer-basierten Leiterpaste können insbesondere intermetallische Diffusionen und elektrochemische Reaktionen mit daran angeschlossenen Kupfer-Stromkabeln verhindert werden.

Gemäß einer besonders bevorzugten Ausführungsform kann vorgesehen sein, dass die Leiterpaste durch ein Siebdruckverfahren auf die Oberfläche des Substrats aufgebracht wird. Die Siebdrucktechnik ist ein etabliertes Verfahren zum Erzeugen von Leiterbahnen auf Substraten. Im Bereich der Leistungselektronik wird als Substrat häufig ein sogenanntes "Insulated Metal Substrate" (IMS) eingesetzt, welches einen Kern aus Aluminium umfasst und welches von einer elektrisch isolierenden bzw. dielektrischen Schicht umhüllt ist. Der Kern aus Aluminium wird in diesem Fall für eine verbesserte Wärmeleitung eingesetzt. Die Leiterbahnen selbst, die beispielsweise mittels Siebdrucktechnik auf die Isolierschicht aufgetragen werden, sind dabei elektrisch nicht mit dem Kern aus Aluminium kontaktiert.

Ein Ziel der Erfindung ist es jedoch, eine direkte elektrische Kontaktierung von auf dem Substrat angeordneten Leiterbahnen mit dem Substrat selbst zu erzielen. Dies wird ermöglicht, indem durch das vorgeschlagene Verfahren die Leiterbahnen bzw. Leiterflächen direkt auf dem Substrat angeordnet werden können, ohne eine isolierende Schicht dazwischen ausbilden zu müssen. Es wird ein Stoffschluss zwischen gesinterter Leiterpaste und Substrat erzielt, durch den die gesinterte Leiterpaste direkt mit dem Substrat elektrisch und thermisch kontaktiert ist. Dabei können herkömmliche Leiterpasten in Form von Dickschichtpasten oder Sinterpasten eingesetzt werden. Durch die Porosität von Dickschichtpasten können unterschiedliche Wärmeausdehnungen von Leiterpaste und Substrat kompensiert werden, wodurch sich die Zuverlässigkeit der Verbindung zwischen Leiterpaste und Substrat erhöhen lässt, insbesondere bei starker Temperaturwechselbeanspruchung wie beispielsweise im Automobilbereich.

Durch die additive Natur der Siebdrucktechnik, bei der Schichten auf ein Substrat aufgebaut werden, kann zum Metallisieren einer Substrat-Oberfläche darüber hinaus auf den Einsatz von Belichtungs- und Ätz-Verfahren verzichtet werden, was zu Kostenvorteilen des vorgeschlagenen Verfahrens führt.

Eine Dickschichtleiterpaste umfasst gemäß der Erfindung zumindest ein Metallpulver als elektrisch leitfähiges Mittel, ein anorganisches Pulver (z.B. Glasfritten) als Anhaftemittel, sowie organische Binde- und Lösemittel. Die organischen Binde- und Lösemittel führen zu einer pastenähnlichen Konsistenz mit bestimmten rheologischen Eigenschaften, die jedoch auch durch die weiteren Bestandteile der Leiterpaste beeinflusst sind.

In Bezug auf den Bestandteil des elektrisch leitfähigen Metallpulvers kann vorzugsweise vorgesehen sein, dass eine Leiterpaste umfassend ein Kupferpulver verwendet wird. Selbstverständlich ist es aber auch möglich, eine Leiterpaste umfassend ein Silber- und/oder Goldpulver zu verwenden. Der Einsatz von Kupferpulver ist dabei jedoch deutlich kostengünstiger.

Bezüglich des Bestandteils des anorganischen Pulvers kann vorzugsweise vorgesehen sein, dass eine Leiterpaste umfassend ein Glas aus dem PbO-B₂O₃-SiO₂-System und/oder ein Glas umfassend Bi₂O₃ verwendet wird. Dadurch kann während des Sinterprozesses im vorgeschlagenen Verfahren trotz der dabei vorherrschenden, verhältnismäßig geringen Brenntemperaturen eine sehr gute Anhaftung der Leiterpaste am Substrat erzielt werden.

Nach dem Aufdrucken einer Leiterpaste, beispielsweise durch ein im Stand der Technik bekanntes Siebdruckverfahren, verbleibt die Leiterpaste aufgrund ihrer rheologischen Eigenschaften im Wesentlichen auf den entsprechenden Bereichen, ohne nennenswert zu verfließen. Um die auf die Oberfläche des Substrats aufgetragene Leiterpaste optimal auf das Brennen bzw. Sintern vorzubereiten, kann vorzugsweise vorgesehen sein, dass die Leiterpaste vor der ersten Brennphase in einer Trocknungsphase bei einer Temperatur von etwa 80 °C bis etwa 200 °C, vorzugsweise von 100 °C bis 150 °C, besonders bevorzugt bei maximal 130 °C, getrocknet wird, vorzugsweise für eine Zeitspanne von etwa 5 min bis etwa 20 min. Durch diese Trocknungsphase lösen sich die in der Leiterpaste vorhandenen Lösemittel im Wesentlichen vollständig auf. Bevorzugt sind dabei bekannte Trocknungsmethoden wie beispielsweise Infrarot- oder Heißlufttrocknung. Durch den Trocknungsprozess und das damit verbundene Auflösen der Lösemittel in der Leiterpaste erfährt die Leiterpaste einen gewissen Volumenschwund. Diesem kann jedoch bereits im Vorfeld durch ein dementsprechend dickeres Auftragen der Leiterpaste entgegengewirkt werden.

Das Brennen bzw. Sintern der Leiterpaste in der ersten und/oder zweiten Brennphase des vorgeschlagenen Verfahrens kann vorzugsweise in einem Brennofen erfolgen, wobei im Brennofen die Brenntemperatur vorherrscht. Selbstverständlich kann bzw. können auch die Trocknungsphase und/oder die Abkühlphase im Brennofen erfolgen. Vorzugsweise kann dabei ein Brennofen mit einer Fördereinrichtung zum Einsatz kommen.

Abhängig von der verwendeten Werkstoffkombination aus Substrat und Leiterpaste kann ein geeignetes Brennprofil angewendet werden. Eine besondere Ausführungsvariante sieht vor, dass in der ersten Brennphase die Brenntemperatur zumindest zeitweise um etwa 40 °C/min bis etwa 60 °C/min erhöht wird. Weiters kann vorgesehen sein, dass in der ersten Brennphase die Brenntemperatur auf eine maximale Brenntemperatur von etwa 580 °C, vorzugsweise etwa 565 °C, besonders bevorzugt etwa 548 °C, erhöht wird.

Eine Erhitzung der Leiterpaste über 400 °C bis 450 °C gemäß der Erfindung führt dazu, dass sich alle organischen Inhaltsstoffe, wie beispielsweise organische Bindemittel, im Wesentlichen vollständig auflösen und dass sich die inorganischen Bestandteile (z.B. Glaspulver oder Glasfritten) aufweichen. Darüber hinaus setzt bei diesen Temperaturen der Sinterprozess des Metallpulvers ein. Die aufgeweichten Glasbestandteile der Leiterpaste führen in weiterer Folge zu einer guten Anhaftung der Leiterpaste auf dem Substrat.

Die maximale Brenntemperatur ist grundsätzlich durch die Schmelztemperatur von Aluminium begrenzt, die bei etwa 660 °C liegt. Bei Einsatz einer Leiterpaste auf Silberbasis beträgt die maximale Brenntemperatur vorzugsweise etwa 565 °C und bei Einsatz einer Leiterpaste auf Kupferbasis beträgt die maximale Brenntemperatur vorzugsweise etwa 548 °C. Diese Temperaturen ergeben sich aus den Schmelztemperaturen von möglichen dabei entstehenden eutektischen Aluminium-Kupfer bzw. Aluminium-Silber Legierungen.

In Bezug auf die jeweilige maximale Brenntemperatur sind für eine Leiterpaste geeignete Glasbestandteile auszuwählen, deren entsprechende Glasübergangstemperatur (T_{G}) bzw. Schmelztemperatur (T_{S}) an diese maximale Brenntemperatur angepasst sind. Die Glasübergangstemperatur bzw. Schmelztemperatur des Glasbestandteils der entsprechenden Leiterpaste sollte demnach entsprechend unterhalb der angegebenen maximalen Brenntemperaturen liegen, um eine optimale Anhaftung der Leiterpaste auf dem Substrat zu gewährleisten. Geeignet sind insbesondere Gläser aus dem PbO-B₂O₃-SiO₂-System oder Gläser umfassend Bi₂O₃.

Als besonders vorteilhaft hat es sich herausgestellt, wenn das Brennen der Leiterpaste in der zweiten Brennphase für etwa 5 min bis etwa 30 min erfolgt. Grundsätzlich gilt, je länger die Zeitspanne in der zweiten Brennphase ist (bei maximaler Brenntemperatur), desto dichter sintert die Leiterpaste und weist somit bessere Eigenschaften für die Weiterverarbeitung (z.B. Löten und Schweißen) auf. Bei zu langen Zeitspannen in der zweiten Brennphase wird jedoch die Durchlaufzeit in einem typischen Einbrennofen entsprechend verlängert, was sich negativ auf den Gesamtdurchsatz auswirken kann.

In einer weiteren vorteilhaften Ausführungsvariante kann vorgesehen sein, dass in der zweiten Brennphase die vorgebbare maximale Brenntemperatur im Wesentlichen konstant gehalten wird.

Vorzugsweise kann außerdem vorgesehen sein, dass die Leiterpaste in der ersten Brennphase und/oder der zweiten Brennphase einer Schutzgasatmosphäre umfassend Stickstoff ausgesetzt wird. Eine Schutzgasatmosphäre (z.B. Stickstoff) ist für den Einbrand von Kupfer-Leiterbahnpasten vorteilhaft, um die Oxidation des Leiterbahnmaterials zu unterbinden (es kann abhängig von der Brennphase ein Restsauerstoffgehalt von einigen ppm vorliegen). Die organischen Binder eines solchen Materials bzw. der Leiterpaste können dabei so konzipiert sein, dass sie unter einer Stickstoffatmosphäre reduziert werden können. Für Silber-Leiterbahnpasten kann wiederum eine herkömmliche Luft-Atmosphäre vorteilhaft sein, weil es hierbei zu keiner nennenswerten Beeinträchtigung der Leiterbahnoberfläche durch Oxidation kommt. Die hierbei eingesetzten organischen Binder können über den Luftsauerstoff oxidiert werden.

In einer bevorzugten Ausführungsform der Erfindung kann vorgesehen sein, dass in der Abkühlphase die Brenntemperatur zumindest zeitweise um etwa 20 °C/min bis etwa 40 °C/min, vorzugsweise um etwa 30 °C/min, reduziert wird. Vorzugsweise erfolgt dabei das Abkühlen bis auf Umgebungstemperatur. Je langsamer die Abkühlung erfolgt, desto geringer sind die mechanischen Auswirkungen der Verbindung zwischen Leiterpaste und Substrat aufgrund unterschiedlicher Wärmeausdehnungskoeffizienten der verwendeten Werkstoffe.

Durch die typische Oxidation der gesinterten Leiterpaste, die während des Brenn- bzw. Sinterprozesses durch die dabei vorherrschenden hohen Temperaturen erfolgt, ist vorgesehen, dass die Oberfläche der Leiterpaste nach der Abkühlung entsprechend mechanisch nachbehandelt wird, um die weitere Verarbeitung zu erleichtern, beispielsweise für nachfolgende Löt- oder Schweißverfahren.

Gemäß einer bevorzugten Ausführungsform kann vorgesehen sein, dass die Leiterpaste mit einer Dicke von etwa 10 µm bis etwa 100 µm auf die Oberfläche des Substrats aufgebracht wird. Selbstverständlich ist es auch möglich, Leiterpasten mit einer Dicke von weniger als 10 µm oder Leiterpasten mit einer Dicke von mehr als 100 µm auf die Oberfläche des Substrats aufzubringen. Es kann auch vorgesehen sein, dass das vorgeschlagene Verfahren mehrmals hintereinander angewendet wird, um die sich insgesamt ergebende Dicke der Leiterpaste zu erhöhen.

Weitere Einzelheiten und Vorteile der vorliegenden Erfindung werden anhand der nachfolgenden Figurenbeschreibung erläutert. Dabei zeigt:
- Fig. 1: einen Schnitt durch ein Substrat mit darauf angeordneter Leiterpaste und
- Fig. 2: ein Brennprofil der Brenntemperatur in Bezug auf die Zeit für ein Ausführungsbeispiel des vorgeschlagenen Verfahrens.

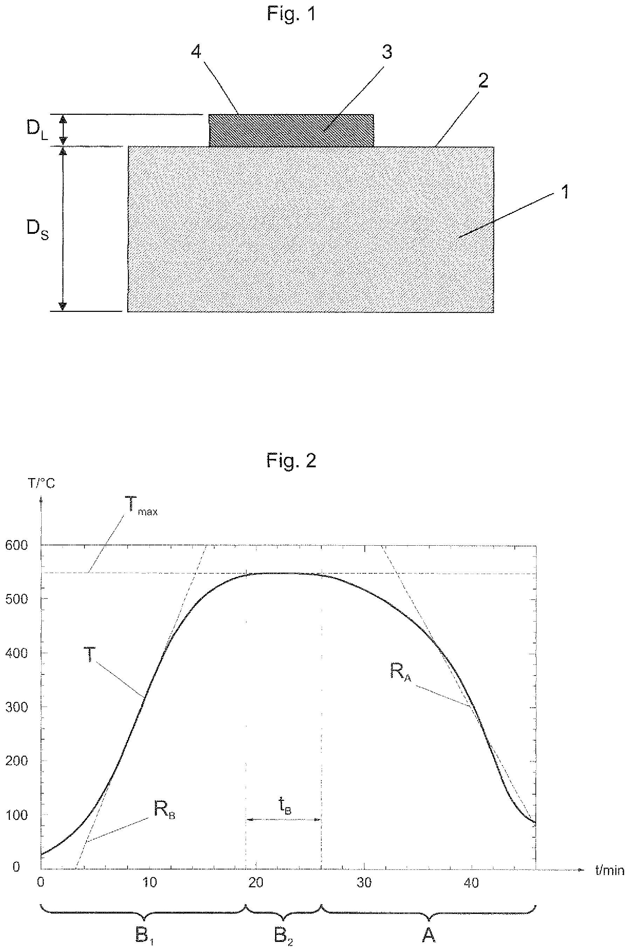

Fig. 1 zeigt einen (nicht maßstäblichen) Querschnitt durch ein Substrat 1 aus im Wesentlichen reinem Aluminium bzw. einer hochreinen Aluminiumlegierung nach Durchführung eines vorgeschlagenen Verfahrens. Das Substrat 1 besteht dabei beispielsweise aus einem Aluminium-Werkstoff mit der Güte EN AW-1050A nach Europäischer Norm EN 573, der mindestens 99,5 Gew.-% Aluminium enthält. Das Substrat 1 weist eine Dicke D_{S} von etwa 2 mm und eine im Wesentlichen ebene Oberfläche 2 auf. Generell kann das Substrat 1 eine Dicke D_{S} von zumindest 1 mm aufweisen, während eine maximal sinnvolle Dicke D_{S} durch die weitere Verarbeitung des Substrats 1 begrenzt sein kann.

Auf die Oberfläche 2 des Substrats 1 wurde mittels Siebdruckverfahren eine Leiterpaste 3 auf Kupferbasis aufgebracht, d.h. die verwendete Leiterpaste 3 enthält ein Kupferpulver als elektrisch leitfähigen Bestandteil. Das Substrat 1 mitsamt Leiterpaste 3 wurde gemäß einem vorgeschlagenen Verfahren entsprechend dem Brennprofil aus Fig. 2 behandelt, um ein lötbares Aluminium-Substrat 1 zu erhalten. Die Dicke D_{L} der gebrannten bzw. gesinterten Leiterpaste 3 nach Anwendung des vorgeschlagenen Verfahrens beträgt in diesem Beispiel etwa 35 µm. Die Dicke D_{L} der gebrannten bzw. gesinterten Leiterpaste 3 kann beispielsweise für Kupfer-Leiterbahnpasten etwa 20 µm bis etwa 40 µm und für Silber-Leiterbahnpasten etwa 10 µm bis etwa 20 µm betragen. Zur Verbesserung der Löteigenschaften der im vorgeschlagenen Verfahren gebrannten bzw. gesinterten Leiterpaste 3 wurde die Oberfläche 4 der gesinterten Leiterpaste 3 mechanisch nachbehandelt, beispielsweise gebürstet.

Fig. 2 zeigt ein mögliches Brennprofil für das vorgeschlagene Verfahren. Das gezeigte Diagramm stellt dabei den zeitlichen Verlauf der Brenntemperatur T in einem Brennofen dar, in dem die erste Brennphase B₁, die zweite Brennphase B₂ und die Abkühlphase A durchgeführt wurden. In der ersten Brennphase B₁ wurde ausgehend von einer Umgebungstemperatur von etwa 22 °C die Brenntemperatur T kontinuierlich bis zu einer vorgebbaren maximalen Brenntemperatur Tₘₐₓ von etwa 542 °C erhöht. Der zeitliche Verlauf der Brenntemperatur T in der ersten Brennphase B₁ ist dabei im Wesentlichen S-förmig mit einem im Wesentlichen linearen Abschnitt, in dem die Brenntemperatur T mit einer Rate R_{B} von etwa 46 °C/min erhöht wurde.

Nach Erreichen der vorgebbaren maximalen Brenntemperatur Tₘₐₓ wurde in der zweiten Brennphase B₂ die Leiterpaste 3 und das Substrat 1 für einen vorgebbaren Zeitraum t_{B} von etwa 9 min der vorgebbaren maximalen Brenntemperatur Tₘₐₓ von etwa 542 °C ausgesetzt und damit die Leiterpaste 3 gebrannt bzw. gesintert.

In der nachfolgenden Abkühlphase A wurde die Brenntemperatur T kontinuierlich reduziert, wobei die Brenntemperatur T über die Zeit t in einem im Wesentlichen S-förmigen Verlauf abnimmt. Angenähert betrug die Reduktionsrate R_{A} der Brenntemperatur T in der Abkühlphase A im Mittel etwa 33 °C/min.

## Patentansprüche

1. Verfahren zur Herstellung eines metallisierten Substrats (1), wobei das Substrat (1) zumindest teilweise, vorzugsweise vollständig, aus Aluminium und/oder einer Aluminiumlegierung besteht, **dadurch gekennzeichnet, dass** auf einer Oberfläche (2) des Substrats (1) zumindest bereichsweise eine Leiterpaste (3) umfassend zumindest ein Metallpulver als elektrisch leitfähiges Mittel, ein anorganisches Pulver als Anhaftemittel sowie organische Binde- und Lösemittel aufgebracht wird, in einer ersten Brennphase (B₁) die Leiterpaste (3) einer im Wesentlichen kontinuierlich steigenden Brenntemperatur (T) ausgesetzt wird, wobei in der ersten Brennphase (B₁) die Brenntemperatur (T) zumindest zeitweise um etwa 40 °C/min bis etwa 60 °C/min erhöht wird, wobei die Brenntemperatur (T) auf eine vorgebbare maximale Brenntemperatur (Tₘₐₓ) kleiner 660 °C erhöht wird, wobei die Leiterpaste (3) über 400 °C bis 450 °C erhitzt wird, in einer zweiten Brennphase (B₂) die Leiterpaste (3) für einen vorgebbaren Zeitraum (t_{B}) im Wesentlichen der vorgebbaren maximalen Brenntemperatur (Tₘₐₓ) ausgesetzt wird, in einer Abkühlphase (A) die Leiterpaste (3) abgekühlt wird und in einer Nachbehandlungsphase eine Oberfläche (4) der Leiterpaste (3) mechanisch nachbehandelt, vorzugsweise gebürstet, wird.

2. Verfahren nach Anspruch 1, **dadurch gekennzeichnet, dass** die Leiterpaste (3) durch ein Siebdruckverfahren auf die Oberfläche (2) des Substrats (1) aufgebracht wird.

3. Verfahren nach Anspruch 1 oder 2, **dadurch gekennzeichnet, dass** eine Leiterpaste (3) umfassend ein Kupferpulver verwendet wird.

4. Verfahren nach einem der Ansprüche 1 bis 3, **dadurch gekennzeichnet, dass** eine Leiterpaste (3) umfassend ein Glas aus dem PbO-B₂O₃-SiO₂-System und/oder ein Glas umfassend Bi₂O₃ verwendet wird.

5. Verfahren nach einem der Ansprüche 1 bis 4, **dadurch gekennzeichnet, dass** die Leiterpaste (3) vor der ersten Brennphase (B₁) in einer Trocknungsphase bei einer Temperatur von etwa 80 °C bis etwa 200 °C, vorzugsweise von 100 °C bis 150 °C, besonders bevorzugt bei maximal 130 °C, getrocknet wird, vorzugsweise für eine Zeitspanne von etwa 5 min bis etwa 20 min.

6. Verfahren nach einem der Ansprüche 1 bis 5, **dadurch gekennzeichnet, dass** zumindest das Brennen der Leiterpaste (3) in der ersten Brennphase (B₁) und/oder der zweiten Brennphase (B₂) in einem Brennofen erfolgt, wobei im Brennofen die Brenntemperatur (T) vorherrscht.

7. Verfahren nach einem der Ansprüche 1 bis 6, **dadurch gekennzeichnet, dass** in der ersten Brennphase (B₁) die Brenntemperatur (T) auf eine maximale Brenntemperatur (Tₘₐₓ) von etwa 580 °C, vorzugsweise etwa 565 °C, besonders bevorzugt etwa 548 °C, erhöht wird.

8. Verfahren nach einem der Ansprüche 1 bis 7, **dadurch gekennzeichnet, dass** das Brennen der Leiterpaste (3) in der zweiten Brennphase (B₂) für etwa 5 min bis etwa 30 min erfolgt.

9. Verfahren nach einem der Ansprüche 1 bis 8, **dadurch gekennzeichnet, dass** in der zweiten Brennphase (B₂) die vorgebbare maximale Brenntemperatur (Tₘₐₓ) im Wesentlichen konstant gehalten wird.

10. Verfahren nach einem der Ansprüche 1 bis 9, **dadurch gekennzeichnet, dass** die Leiterpaste (3) in der ersten Brennphase (B₁) und/oder der zweiten Brennphase (B₂) einer Schutzgasatmosphäre umfassend Stickstoff ausgesetzt wird.

11. Verfahren nach einem der Ansprüche 1 bis 10, **dadurch gekennzeichnet, dass** in der Abkühlphase (A) die Brenntemperatur (T) zumindest zeitweise um etwa 20 °C/min bis etwa 40 °C/min, vorzugsweise um etwa 30 °C/min, reduziert wird.

12. Verfahren nach einem der Ansprüche 1 bis 11, **dadurch gekennzeichnet, dass** die Leiterpaste (3) mit einer Dicke von etwa 10 µm bis etwa 100 µm auf die Oberfläche (2) des Substrats (1) aufgebracht wird.

## Claims

1. A method of producing a metallized substrate (1), wherein the substrate (1) at least partially and preferably entirely comprises aluminum and/or an aluminum alloy, **characterised in that** a conductor paste (3) comprising at least a metal powder as an electrically conductive agent, an inorganic powder as a bonding agent and organic binding and dissolving agents is applied at least region-wise to a surface (2) of the substrate (1), in a first firing phase (B₁) the conductor paste (3) is exposed to a substantially continuously increasing firing temperature (T), wherein in the first firing phase (B₁) the firing temperature (T) is increased at least temporarily by between about 40°C/min and about 60°C/min, wherein the firing temperature (T) is increased to a predeterminable maximum firing temperature (Tₘₐₓ) of less than 660°C, wherein the conductor paste (3) is heated over between 400°C and 450°C, in a second firing phase (B₂) the conductor paste (3) is exposed substantially to the predeterminable maximum firing temperature (Tₘₐₓ) for a predeterminable period of time (t_{B}), in a cooling phase (A) the conductor paste (3) is cooled down and in a post-treatment phase a surface (4) of the conductor paste (3) is mechanically post-treated, preferably brushed.

2. A method as set forth in claim 1 **characterised in that** the conductor paste (3) is applied to the surface (2) of the substrate (1) by a screen printing process.

3. A method as set forth in claim 1 or claim 2 **characterised in that** a conductor paste (3) including a copper powder is used.

4. A method as set forth in one of claims 1 through 3 **characterised in that** a conductor paste (3) including a glass from the PbO-B₂O₃-SiO₂ system and/or a glass including Bi₂O₃ is used.

5. A method as set forth in one of claims 1 through 4 **characterised in that** prior to the first firing phase (B₁) the conductor paste (3) is dried in a drying phase at a temperature of between about 80°C and about 200°C, preferably between 100°C and 150°C, particularly preferably at a maximum 130°C, preferably for a period of time of between about 5 min and about 20 min.

6. A method as set forth in one of claims 1 through 5 **characterised in that** at least firing of the conductor paste (3) in the first firing phase (B₁) and/or the second firing phase (B₂) is effected in a firing furnace, the firing temperature (T) prevailing in the firing furnace.

7. A method as set forth in one of claims 1 through 6 **characterised in that** in the first firing phase (B₁) the firing temperature (T) is increased to a maximum firing temperature (Tₘₐₓ) of about 580°C, preferably about 565°C, particularly preferably about 548°C.

8. A method as set forth in one of claims 1 through 7 **characterised in that** firing of the conductor paste (3) is effected in the second firing phase (B₂) for between about 5 min and about 30 min.

9. A method as set forth in one of claims 1 through 8 **characterised in that** in the second firing phase (B₂) the predeterminable maximum firing temperature (Tₘₐₓ) is kept substantially constant.

10. A method as set forth in one of claims 1 through 9 **characterised in that** in the first firing phase (B₁) and/or the second firing phase (B₂) the conductor paste (3) is exposed to a protective gas atmosphere including nitrogen.

11. A method as set forth in one of claims 1 through 10 **characterised in that** in the cooling phase (A) the firing temperature (T) is reduced at least temporarily by between about 20°C/min and about 40°C/min, preferably by about 30°C/min.

12. A method as set forth in one of claims 1 through 11 **characterised in that** the conductor paste (3) is applied in a thickness of between about 10µm and about 100µm to the surface (2) of the substrate (1).

## Revendications

1. Procédé de fabrication d'un substrat (1) métallisé, le substrat (1) étant composé au moins partiellement, de préférence totalement, d'aluminium et/ou d'un alliage d'aluminium, **caractérisé en ce que**, sur une surface (2) du substrat (1), une pâte conductrice (3), comprenant au moins une poudre métallique en tant que moyen électriquement conducteur, une poudre inorganique en tant que moyen d'adhérence ainsi que des liants et des solvants, est appliquée au moins par tronçons, la pâte conductrice (3) est, dans une première phase de cuisson (B₁), exposée à une température de cuisson (T) qui augmente essentiellement constamment, la température de cuisson (T) étant, dans la première phase de cuisson (B₁), augmentée au moins temporairement d'environ 40 °C/min à environ 60 °C/min, la température de cuisson (T) étant augmentée jusqu'à une température de cuisson maximale (Tₘ) pouvant être prédéfinie inférieure à 660 °C, la pâte conductrice (3) étant chauffée à plus de 400 °C à 450 °C, la pâte conductrice (3) étant, dans une deuxième phase de cuisson (B₂), pendant une période (t_{B}) pouvant être prédéfinie, exposée essentiellement à la température de cuisson maximale (Tₘ) pouvant être prédéfinie, la pâte conductrice (3) étant refroidie dans une phase de refroidissement (A) et, dans une phase de traitement ultérieur, une surface (4) de la pâte conductrice (3) étant traitée ultérieurement mécaniquement, de préférence brossée.

2. Procédé selon la revendication 1, **caractérisé en ce que** la pâte conductrice (3) peut être appliquée sur la surface (2) du substrat (1) par un procédé de sérigraphie.

3. Procédé selon la revendication 1 ou 2, **caractérisé en ce qu'**une pâte conductrice (3) comprenant une poudre de cuivre est utilisée.

4. Procédé selon l'une des revendications 1 à 3, **caractérisé en ce qu'**une pâte conductrice (3) comprenant un verre issu du système PbO-B₂O₃-SiO₂ et/ou un verre comprenant Bi₂O₃ est utilisée.

5. Procédé selon l'une des revendications 1 à 4, **caractérisé en ce que**, avant la première phase de cuisson (B₁), la pâte conductrice (3) est, dans une phase de séchage, séchée à une température d'environ 80 °C à environ 200 °C, de préférence de 100 °C à environ 150 °C, de façon particulièrement préférée à 130 °C maximum, de préférence pendant une période de temps d'environ 5 min. à environ 20 min.

6. Procédé selon l'une des revendications 1 à 5, **caractérisé en ce qu'**au moins la cuisson de la pâte conductrice (3) dans la première phase de cuisson (B₁) et/ou dans la deuxième phase de cuisson (B₂) s'effectue dans un four de cuisson, la température de cuisson (T) régnant dans le four de cuisson.

7. Procédé selon l'une des revendications 1 à 6, **caractérisé en ce que**, dans la première phase de cuisson (B₁), la température de cuisson (T) est augmentée à une température de cuisson maximale (Tₘₐₓ) d'environ 580 °C, de préférence d'environ 565 °C, de façon particulièrement préférée d'environ 548 °C.

8. Procédé selon l'une des revendications 1 à 7, **caractérisé en ce que** la cuisson de la pâte conductrice (3) dans la deuxième phase de cuisson (B₂) s'effectue pendant environ 5 min. à environ 30 min.

9. Procédé selon l'une des revendications 1 à 8, **caractérisé en ce que**, dans la deuxième phase de cuisson (B₂), la température de cuisson maximale (Tₘₐₓ) pouvant être prédéfinie est maintenue essentiellement constante.

10. Procédé selon l'une des revendications 1 à 9, **caractérisé en ce que**, dans la première phase de cuisson (B₁) et/ou dans la deuxième phase de cuisson (B₂), la pâte conductrice (3) est exposée à une atmosphère de gaz protecteur comprenant de l'azote.

11. Procédé selon l'une des revendications 1 à 10, **caractérisé en ce que**, dans la phase de refroidissement (A), la température de cuisson (T) est, au moins temporairement, réduite d'environ 20 °C/min à environ 40 °C/min, de préférence d'environ 30 °C/min.

12. Procédé selon l'une des revendications 1 à 11, **caractérisé en ce que** la pâte conductrice (3) est appliquée sur la surface (2) du substrat (1) à raison d'une épaisseur d'environ 10 µm à environ 100 µm.
